(19) Europäisches Patentamt
European Patent Office
Office européen des brevets

(11) **EP 2 867 969 B1**

(12) **EUROPÄISCHE PATENTSCHRIFT**

(45) Veröffentlichungstag und Bekanntmachung des Hinweises auf die Patenterteilung:
**17.01.2018 Patentblatt 2018/03**

(21) Anmeldenummer: **13729368.4**

(22) Anmeldetag: **18.06.2013**

(51) Int Cl.:
*H02H 7/18* (2006.01)     *H02J 1/06* (2006.01)

(86) Internationale Anmeldenummer:
**PCT/EP2013/062566**

(87) Internationale Veröffentlichungsnummer:
**WO 2014/001136 (03.01.2014 Gazette 2014/01)**

(54) **BATTERIESYSTEM UND KRAFTFAHRZEUG MIT BATTERIESYSTEM**

BATTERY SYSTEM AND MOTOR VEHICLE WITH BATTERY SYSTEM

SYSTÈME DE BATTERIE ET VÉHICULE AUTOMOBILE ÉQUIPÉ D'UN SYSTÈME DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.06.2012 DE 102012211088**

(43) Veröffentlichungstag der Anmeldung:
**06.05.2015 Patentblatt 2015/19**

(73) Patentinhaber:
• **Robert Bosch GmbH**
  **70442 Stuttgart (DE)**
• **Samsung SDI Co., Ltd.**
  **Gyeonggi-do 449-577 (KR)**

(72) Erfinder: **FINK, Holger**
**70567 Stuttgart (DE)**

(74) Vertreter: **Bee, Joachim**
**Robert Bosch GmbH**
**C/IPE**
**Wernerstrasse 1**
**70469 Stuttgart (DE)**

(56) Entgegenhaltungen:
**EP-A2- 2 075 892     EP-A2- 2 337 182**
**US-B1- 6 339 526**

EP 2 867 969 B1

**Beschreibung**

Die vorliegende Erfindung betrifft ein Batteriesystem, das eine Batteriemanagementeinheit, eine Batteriezellenüberwachungseinheit, wenigstens eine Batteriezelle und eine Sicherheitselektronik für die Batteriezelle umfasst. Die Sicherheitselektronik weist einen ersten Komparator und einen Alarmsignalausgang für ein Alarmsignal auf. Ferner betrifft die Erfindung ein Kraftfahrzeug mit dem Batteriesystem.

Stand der Technik

Es zeichnet sich ab, dass in Zukunft sowohl bei stationären Anwendungen, z. B. bei Windkraftanlagen, in Fahrzeugen, z. B. in Hybrid- und Elektrofahrzeuge, und bei Laptops und Mobiltelefonen Lithium-Ionen-Batteriesysteme zum Einsatz kommen werden, an die sehr hohe Anforderungen bezüglich Zuverlässigkeit, Sicherheit, Leistungsfähigkeit und Lebensdauer gestellt werden.

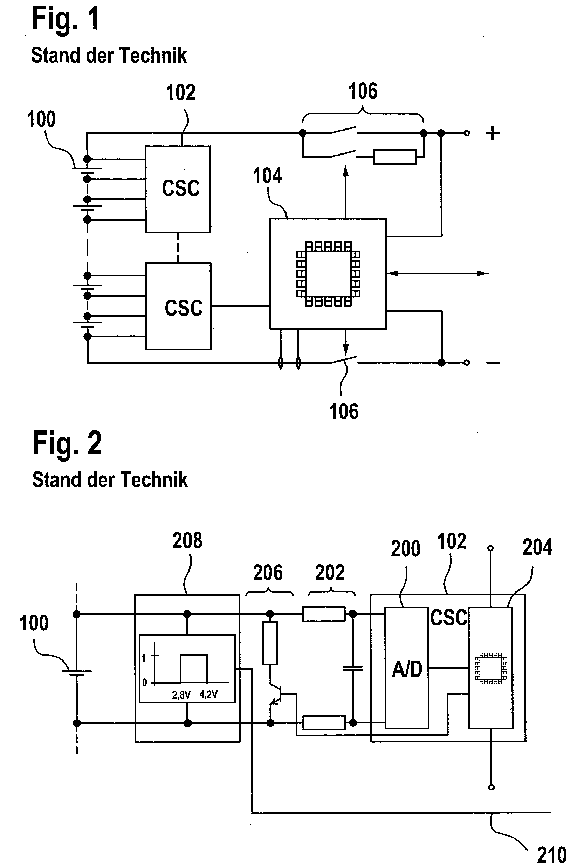

Der prinzipielle funktionale Aufbau eines Batteriesystems gemäß des Standes der Technik ist in der Figur 1 gezeigt. Um geforderte Leistungs- und Energiedaten mit einem solchen Batteriesystem zu erzielen, werden meist einzelne Batteriezellen 100 in Serie und teilweise zusätzlich parallel zu einer Batterie zusammengeschaltet. Eine Gruppe von Batteriezellen 100 ist dabei jeweils an eine von mehreren Batteriezellenüberwachungseinheiten 102, englisch auch Cell Supervision Circuit oder CSC genannt, angeschlossen. Eine weitere Funktionseinheit bildet das Batteriemanagementsystem 104, an dem die Batteriezellenüberwachungseinheiten 102 angeschlossen sind. Das Batteriemanagementsystem 104 sorgt dabei für hohe Sicherheit, Performance und Lebensdauer des Batteriesystems. Es umfasst neben einer Batteriezustandserkennung auch Diagnose- und Sicherheits-Funktionen und Kommunikationsschnittstellen für andere Systeme, etwa ein Thermomanagement der Batterie.

Eine Batterietrenneinheit 106, die zwischen den Batteriezellen 100 und Polen des Batteriesystems angeordnet ist, übernimmt u. a. ein Zu- und Abschalten der Batterie an bzw. von Verbrauchern. Die Batterietrenneinheit 106 wird vom Batteriemanagementsystem 104 gesteuert und gewährleistet die Absicherung des Batteriesystems gegen unzulässig hohe Ströme und Spannungen und bietet Sicherheitsfunktionen, wie z. B. ein zweipoliges Abtrennen der Batteriezellen 100 von den Batteriepolen, etwa bei Wartungsarbeiten am Batteriesystem. In herkömmlichen Batteriemanagementsystemen werden dazu heute üblicherweise pauschale Vorhalte bzw. Sicherheitsabstände einkalkuliert, um die mit höchster Priorität einzuhaltende Sicherheit des Batteriesystems nicht aus Gründen der Bereitstellung einer zu hohen Leistungsfähigkeit zu gefährden.

Die Funktion einer herkömmlichen Batteriezellenüberwachungseinheit 102 ist in der Figur 2 gezeigt. Die Batteriezellenüberwachungseinheit 102 umfasst bekanntermaßen einen Analog-Digital-Wandler 200, der über eine Filterschaltung 202 mit einer der Batteriezellen 100 verbunden ist. Der Analog-Digital-Wandler 200 digitalisiert eine Batteriezellenmomentanspannung der Batteriezelle 100 und stellt diese einer Auswerteelektronik 204 zur Verfügung. Die Auswerteelektronik 204 kann daraufhin ein Steuersignal für eine der Batteriezelle 100 parallel geschaltete Ladungszustandsausgleichschaltung 206, engl. auch cell balancing genannt, bereitstellen. Zur Gewährleistung eines sicheren Betriebs der Batteriezelle 100 ist derselben häufig auch ein Komparator 208 parallel geschaltet. Da bekannt ist, dass herkömmliche Lithium-Ionen-Batteriezellen 100 eine Betriebsspannung von typischerweise 2,8 Volt bis 4,2 Volt aufweisen, ist der Komparator 208 so ausgelegt, dass er bei einem Unter- oder Überschreiten der unteren bzw. oberen Betriebsspannung ein Alarmsignal auf einem Alarmsignalbus 210 erzeugt.

Die Messung der Batteriezellenspannung, einerseits durch die Batteriezellenüberwachungseinheit 102 und andererseits durch den Komparator 208, gewährleistet also heutzutage bereits eine verhältnismäßig sichere Überwachung von Batteriezellen 100.

Die US 6,339,526 B1, die als nächstliegender Stand der Technik gesehen wird, offenbart einen Abschaltschaltkreis für geringe Spannungen, welcher eine Überwachungsschaltung umfasst, die zwischen einen Eingang und einen Ausgang des Abschaltschaltkreises gekoppelt ist. Der Abschaltschaltkreis ist dazu ausgebildet, eine Last von ihrem Ausgang zu trennen, wenn eine Spannung an ihrem Eingang unter einen vorbestimmten Schwellwert fällt.

Ferner offenbart die EP 2 075 892 A2 ein Zellbalancing-System mit einer Vielzahl von zu Gruppen zusammenschalteten Batteriezellen, mehreren Controller- sowie Überwachungs-Einheiten und Bypass-Pfaden, über welche ein gesteuerter Ladungsausgleich zwischen den Batteriezellen stattfinden kann.

Offenbarung der Erfindung

Erfindungsgemäß wird ein Batteriesystem gemäß Anspruch 1 zur Verfügung gestellt. Das Batteriesystem umfasst eine Batteriemanagementeinheit, eine Batteriezellenüberwachungseinheit, wenigstens eine Batteriezelle und eine Sicherheitselektronik für die Batteriezelle. Die Sicherheitselektronik weist einen ersten Komparator und einen Alarmsignalausgang für ein Alarmsignal auf. Der erste Komparator vergleicht eine Batteriezellenspannung der Batteriezelle mit einem vorbestimmten Spannungsschwellwert und erzeugt in Abhängigkeit des Vergleichs das Alarmsignal. Der Spannungsschwellwert ist dabei kleiner als die Batteriezellenspannung in einem Normalbetrieb und größer als ein kritischer Spannungswert. Ferner ist der wenigstens einen Batteriezelle eine Begleitelektronik parallel geschaltet. Erfindungsgemäß bildet eine spezifizierte Spannungsuntergrenze der Begleitelektronik oder der Batteriezellenüberwachungseinheit den kritischen Spannungswert. Ferner wird ein Kraftfahrzeug mit dem Batteriesystem zur Verfügung gestellt, wobei das Batteriesystem mit einem Antriebssystem des Kraftfahrzeugs verbunden ist. Das erfindungsgemäße Batteriesystem mit Sicherheitselektronik ermöglicht auf vorteilhafte Weise einen sicheren Betrieb einer Batteriezelle. Die Sicherheitselektronik überwacht dabei nicht wie etwa bekannte Begleitelektroniken die Batteriezellenspannung im Normalbetrieb, sondern vergleicht die Batteriezellenspannung mit dem Spannungsschwellwert, der kleiner als die Batteriezellenspannung in Normalbetrieb ist. Das heißt die Sicherheitselektronik greift im Wesentlichen in Fehlerfällen ein und erzeugt dann ein Alarmsignal, wenn die Batteriezellenspannung der Batteriezelle den normalen Bereich verlässt und sich einem kritischen Spannungswert, insbesondere einer negativen Spannung, nähert.

Tritt im Batteriesystem ein Fehlerfall auf, etwa weil ein am Batteriesystem angeschlossener Verbraucher kurzgeschlossen ist oder weil eine Batteriezelle selbst beschädigt ist, so lösen im Allgemeinen Batteriezellensicherungen aus, die in den Batteriezellen aus Sicherheitsgründen integriert sind. Dabei können an den Batteriezellenüberwachungseinheiten, die typischerweise mit den Batteriezellen verbunden sind, hohe negative Spannungen auftreten. Löst die Batteriezellensicherung einer bestimmten Batteriezelle aus, so kann an dieser Batteriezellensicherung und somit an der jeweiligen Batteriezellenüberwachungseinheit die gesamte Spannung der übrigen Batteriezellen mit negativem Vorzeichen anliegen. Die Batteriezellenüberwachungseinheit kann durch hohe negative Spannungen Schaden nehmen, z. B. sich entzünden und abbrennen.

Durch das Auslösen einer Batteriezellensicherung verringert sich im Allgemeinen die Batteriezellenspannung der betroffenen Batteriezelle. Der erste Komparator erzeugt bevorzugt das Alarmsignal, wenn der Vergleich ergibt, dass die Batteriezellenspannung kleiner als der Spannungsschwellwert ist. Der Komparator detektiert so im Wesentlichen den verbraucherseitigen Kurzschluss.

Löst beispielsweise eine Batteriezellensicherung einer Batteriezelle aus, wobei die Batteriezellenspannung eben dieser Batteriezelle in einem zulässigen Bereich von typischerweise etwa 2,8 V bis etwa 4,2 V bleibt, so erkennt die Sicherheitselektronik, dass im Wesentlichen kein kritischer Zustand vorliegt und der erste Komparator erzeugt in diesem Fall insbesondere kein Alarmsignal.

Zwar sind auch Batteriezellenüberwachungseinheiten bekannt, die eine Batteriezellenspannung messen und weiterverarbeiten. Die Sicherheitselektronik des erfindungsgemäßen Batteriesystems bildet jedoch insbesondere ein redundantes, unabhängiges bzw. zusätzliches Messmittel zu den bekannten Batteriezellenüberwachungseinheiten, das eine hohe Sicherheitseinstufung für mit der Sicherheitselektronik ausgestatte Batteriesysteme ermöglicht. Die Sicherheitselektronik kann auf vorteilhafte Weise eine Einstufung eines solchen Batteriesystems z. B. in ASIL (Automotive Savety Integrity Level) C oder D ermöglichen.

Gemäß eines bevorzugten Ausführungsbeispiels umfasst die Begleitelektronik einen zweiten Komparator. Der zweite Komparator überwacht insbesondere die Batteriezellenspannung der Batteriezelle im Normalbetrieb. Der Normalbetrieb ist im Wesentlichen ein Spannungsbereich für die Batteriezellenspannung, der zwischen einer Ladeschlussspannung und einer Entladeschlussspannung der Batteriezelle liegt. Bevorzugt ist die Batteriezelle eine Lithium-Ionen-Batteriezelle. Eine Lithium-Ionen-Batteriezelle weist im Allgemeinen eine Ladeschlussspannung von etwa 4,2 V und eine Entladeschlussspannung von etwa 2,8 V oder 2,5 V auf. Bei sehr tiefen Umgebungstemperaturen von beispielsweise -30°C kann die Entladeschlussspannung auch niedriger, z. B. bei 2,1 V, liegen.

Die Begleitelektronik kann an jede Batteriezelle angeschlossen werden und prüft mittels des zweiten Komparators im Wesentlichen, ob die Batteriezellenspannung die Ladeschlussspannung überschreitet oder die Entladeschlussspannung unterschreitet. In Abhängigkeit dieser Prüfungen kann die Begleitelektronik ein weiteres Alarmsignal erzeugen. Vorzugsweise ergänzt die Sicherheitselektronik die Begleitelektronik und die Batteriezellenüberwachungseinheit, um die Betriebssicherheit des Batteriesystems zu erhöhen.

Begleitelektroniken und Batteriezellenüberwachungseinheiten weisen im Allgemeinen einen niedrigen Eingangswiderstand auf und nehmen daher bei hohen negativen Eingangsspannungen leicht Schaden. Eine beispielsweise in einem Datenblatt spezifizierte Spannungsuntergrenze der Begleitelektronik oder der Batteriezellenüberwachungseinheit bildet bevorzugt den kritischen Spannungswert. Der erste Komparator ist vorzugsweise so ausgelegt, dass er das Alarmsignal erzeugt, bevor die Batteriezellenspannung den kritischen Spannungswert erreicht, so dass die Begleitelektronik und die Batteriezellenüberwachungseinheit in einem Fehlerfall vor Schaden geschützt werden können.

Wenn der erste Komparator einen Eingangswiderstand von vorzugsweise mehreren Kiloohm oder Megaohm aufweist, ist der erste Komparator insbesondere robust gegen hohe anliegende Spannung.

Ferner ist es mit Vorteil versehen, wenn das Batteriesystem mit einer Batterietrenneinheit ausgestattet ist, die das Batteriesystem in Abhängigkeit des Alarmsignals von einem Verbraucher trennt. Ein Verbraucher umfasst im Allgemeinen Elektromotoren, Pulswechselrichter, Inverter und dergleichen. Tritt im Fehlerfall beispielsweise ein Kurzschluss im Verbraucher auf, den der erste Komparator der Sicherheitselektronik erkennt, so kann das Alarmsignal die Batterietrenneinheit derart ansteuern, dass das Batteriesystem insbesondere zweipolig vom Verbraucher getrennt wird. Um eine hohe Betriebs- und Ausfallsicherheit des Batteriesystems gewährleisten zu können, ist eine separate Hardwareleitung bevorzugt, die das Alarmsignal von der Sicherheitselektronik zur Batteriezellenüberwachungseinheit oder zur Batteriemanagementeinheit überträgt.

In einer bevorzugten Ausbildung kann das erfindungsgemäße Batteriesystem einen Kurzschlusspfad umfassen, der die Batteriezellenüberwachungseinheit in Abhängigkeit des Alarmsignals zur Batteriezelle parallel schaltet. Der Kurzschlusspfad bewirkt ein Kurzschließen der jeweiligen Batteriezelle und verhindert dadurch beispielsweise das Entstehen hoher negativer Spannungen im Batteriesystem.

Zeichnungen

Ausführungsbeispiele der Erfindung werden anhand der Zeichnungen und der nachfolgenden Beschreibung näher erläutert. Es zeigen:

Figur 1    ein Batteriesystem aus dem Stand der Technik,

Figur 2    eine Batteriezellenüberwachungseinheit aus dem Stand der Technik,

Figur 3    ein Batteriesystem gemäß eines Ausführungsbeispiels der Erfindung, und

Figur 4    ein Batteriesystem gemäß eines weiteren Ausführungsbeispiels der Erfindung.

Ausführungsformen der Erfindung

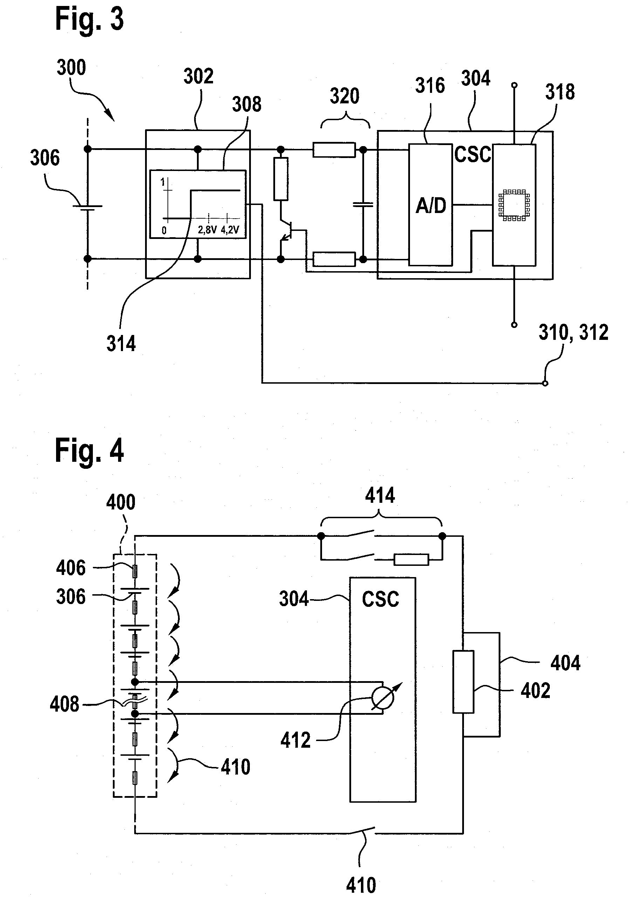

In der Figur 3 ist ein Batteriesystem 300 mit einer Sicherheitselektronik 302 und einer Batteriezellenüberwachungseinheit 304 für eine Batteriezelle 306 gezeigt. Die Sicherheitselektronik 302 umfasst einen ersten Komparator 308 und einen Alarmsignalausgang 310 für ein Alarmsignal 312. Der erste Komparator 308 vergleicht einen vorbestimmten Spannungsschwellwert $U_{schwell}$ 314 mit einer an der Batteriezelle 306 anliegenden Batteriezellenspannung $U_{cell}$. In Abhängigkeit des Vergleichs erzeugt der Komparator das Alarmsignal 312.

Die Batteriezellenüberwachungseinheit 304 dient der Überwachung der Batteriezelle 306. Dazu umfasst die Batteriezellenüberwachungseinheit 304 einen Analog-Digital-Wandler 316 und eine Auswertelektronik 318. Der Analog-Digital-Wandler 316 weist Eingänge auf, die mit den Batteriezellen 306 verbunden sind und dort die Batteriezellenspannung $U_{cell}$ abgreifen. Zur Einhaltung des Abtasttheorems nach Nyquist ist jedem der Analog-Digital-Wandler-Eingänge ein Tiefpassfilter 320 vorgeschaltet. Um die Messgenauigkeit des Analog-Digital-Wandlers nicht durch einen etwaigen Spannungsabfall oder dergleichen zu verschlechtern, sind Eingangswiderstände des Analog-Digital-Wandlers und Widerstände im Tiefpassfilter 320 niederohmig gewählt.

Ferner ist der Batteriezelle 306 auch eine Begleitelektronik 208 parallel geschaltet, wie aus der Figur 2 bekannt ist. In einem Normalbetrieb liegt die Batteriezellenspannung $U_{cell}$ zwischen etwa 2,8 V Entladeschlussspannung $U_{discharged}$ und etwa 4,2 V Ladeschlussspannung $U_{charged}$.

Die Batteriezellenüberwachungseinheit 304 und die Begleitelektronik 208 sind im vorliegenden Ausführungsbeispiel jeweils mit einer Spannungsuntergrenze, die eine kritische Spannung $U_{crit}$ bildet, von z.B. minus fünf Volt, im Datenblatt spezifiziert. Darunter würden sie Schaden nehmen.

Der Spannungsschwellwert $U_{schwell}$ kann deshalb wie folgt vorab festgelegt werden:

$$U_{crit} < U_{schwell} < U_{discharged}.$$

In der Figur 4 ist das Batteriesystem 300 in einem Fehlerfall gezeigt. Mehrere der Batteriezellen 306 bilden in der Figur 4 eine Batterie 400, die mit einem Verbraucher 402 verbunden ist. Der Verbraucher 402 ist beispielsweise aufgrund eines in der Figur 4 schematisch gezeichneten Kurzschlusses 404 defekt. Der Verbraucher 402 bezeichnet allgemein einen Inverter, einen Pulswechselrichter, einen Generator und/oder einen Elektromotor.

Die Batteriezellen 306 umfassen für einen solchen Fehlerfall Batteriezellensicherungen 406. Eine der Batteriezellensicherungen 406 löst an der Stelle 408 aus, d. h., sie trennt den Stromkreis des Batteriesystems 300 an dieser Stelle 408.

Die Batteriezellenüberwachungseinheit 304 überwacht auch während dieses Fehlerfalls die Batteriezellenspannungen $U_{cell}$, die durch Pfeile 410 in der Figur 4 gezeigt sind. Der Analog-Digital-Wandler 316 und der Tiefpassfilter 320 bilden zusammen eine Spannungsmesseinheit 412. Da der Stromkreis des Batteriesystems 300 im vorliegenden Ausführungsbeispiel eine Reihenschaltung einer Anzahl von n Batteriezellen 306 umfasst, liegt im gezeigten Schadensfall beispielsweise eine Schadenspannung von $U_{schad}$ an der Spannungsmesseinheit 412 an.

$$U_{schad} = -(n-1) \cdot U_{cell}$$

Durch den Kurzschluss 404 entsteht eine hohe negative Schadenspannung an der Spannungsmesseinheit 412, die zu ihrer Beschädigung führen würde. Auch eine etwaige an der Batteriezelle 306 angeschlossene Begleitelektronik 208 würde Schaden nehmen.

Der mit der Batteriezelle 306 verbundene erste Komparator 308 vergleicht jedoch die Batteriezellenspannung $U_{cell}(t)$ laufend mit dem Spannungsschwellwert $U_{schwell}$ und erzeugt das Alarmsignal 312, wenn die Batteriezellenspannung $U_{cell}(t)$ den Spannungsschwellwert $U_{schwell}$ unterschreitet.

$$U_{cell}(t) < U_{schwell}$$

Das Alarmsignal 312 wird der Batteriezellenüberwachungseinheit 304 und einer Batteriemanagementeinheit zur Verfügung stellt. Die Batteriemanagementeinheit steuert ihrerseits eine Batterietrenneinheit 414 an, die den Verbraucher 402, und dadurch den Kurzschluss 404, vom Batteriesystem 300 bzw. von der Batterie 400 zweipolig trennt. An der Batteriezellenüberwachungseinheit 304 und der Begleitelektronik 208 liegen so keine hohen negativen Spannungen an.

Das Alarmsignal 312 kann auch direkt die Batterietrenneinheit 410 steuern. Durch dieses Ausführungsbeispiel wird die Sicherheitselektronik 302 unabhängig von etwaiger Software und das Trennen des Batteriesystems 300 vom Verbraucher 402 erfolgt schneller.

Das beschriebene Batteriesystem kann insbesondere die Ausfall- und Betriebssicherheit von mit dem Batteriesystem ausgestatteten Kraftfahrzeugen erhöhen.

**Patentansprüche**

1. Batteriesystem (300) mit
   einer Batteriemanagementeinheit;
   einer Batteriezellenüberwachungseinheit (304);
   wenigstens einer Batteriezelle (306) und
   einer Sicherheitselektronik (302) für die Batteriezelle (306), mit einem ersten Komparator (308) und einem Alarmsignalausgang (310) für ein Alarmsignal (312);
   wobei der erste Komparator (308) eine Batteriezellenspannung (410) der Batteriezelle (306) mit einem vorbestimmten Spannungsschwellwert (314) vergleicht und in Abhängigkeit des Vergleichs das Alarmsignal (312) erzeugt, wobei der Spannungsschwellwert (314) kleiner als die Batteriezellenspannung (410) in einem Normalbetrieb und größer als ein kritischer Spannungswert ist, wobei der wenigstens einen Batteriezelle (306) eine Begleitelektronik (208) parallel geschaltet ist,
   **dadurch gekennzeichnet, dass**
   eine spezifizierte Spannungsuntergrenze der Begleitelektronik (208) oder der Batteriezellenüberwachungseinheit (304) den kritischen Spannungswert bildet.

2. Batteriesystem (300) nach Anspruch 1, wobei die Begleitelektronik einen zweiten Komparator zur Überwachung der Batteriezellenspannung der Batteriezelle im Normalbetrieb umfasst.

3. Batteriesystem (300) nach Anspruch 1 oder 2, wobei der erste Komparator (308) das Alarmsignal (312) erzeugt, wenn der Vergleich ergibt, dass die Batteriezellenspannung (410) kleiner als der Spannungsschwellwert (314) ist.

4. Batteriesystem (300) nach einem der vorhergehenden Ansprüche, wobei der erste Komparator (306) einen Eingangswiderstand von mehreren Kiloohm oder Megaohm aufweist.

5. Batteriesystem (300) nach einem der vorhergehenden Ansprüche, mit einer separaten Hardwareleitung, die das Alarmsignal (312) von der Sicherheitselektronik (302) zur Batteriezellenüberwachungseinheit (304) oder zur Batteriemanagementeinheit überträgt.

6. Batteriesystem (300) nach einem der vorhergehenden Ansprüche, mit einer Batterietrenneinheit (414), die das Batteriesystem (300) in Abhängigkeit des Alarmsignals (312) von einem Verbraucher (402) trennt.

7. Batteriesystem (300) nach einem der vorhergehenden Ansprüche, mit einem Kurzschlusspfad, den die Batteriezellenüberwachungseinheit (304) in Abhängigkeit des Alarmsignals (312) zur Batteriezelle (306) parallel schaltet.

8. Batteriesystem (300) nach einem der vorhergehenden Ansprüche, wobei die Batteriezelle (306) eine Lithium-Ionen-Batteriezelle (306) ist.

9. Kraftfahrzeug mit einem Batteriesystem (300) nach einem der vorhergehenden Ansprüche, wobei das Batteriesystem (300) mit einem Antriebssystem des Kraftfahrzeugs verbunden ist.

**Claims**

1. Battery system (300) comprising
   a battery management unit;
   a battery cell supervision unit (304);
   at least one battery cell (306) and
   safety electronics (302) for the battery cell (306), comprising a first comparator (308) and an alarm signal output (310) for an alarm signal (312);
   wherein the first comparator (308) compares a battery cell voltage (410) of the battery cell (306) with a predetermined voltage threshold value (314) and generates the alarm signal (312) depending on the comparison,
   wherein the voltage threshold value (314) is less than the battery cell voltage (410) during normal operation and greater than a critical voltage value, wherein accompanying electronics (208) are connected in parallel with the at least one battery cell (306),
   **characterized in that**
   a specified voltage lower limit of the accompanying electronics (208) or of the battery cell supervision unit (304) forms the critical voltage value.

2. Battery system (300) according to Claim 1, wherein the accompanying electronics comprise a second comparator for monitoring the battery cell voltage of the battery cell during normal operation.

3. Battery system (300) according to Claim 1 or 2, wherein the first comparator (308) generates the alarm signal (312) when the comparison shows that the battery cell voltage (410) is less than the voltage threshold value (314).

4. Battery system (300) according to one of the preceding claims, wherein the first comparator (306) has an input resistance of several kiloohms or megaohms.

5. Battery system (300) according to one of the preceding claims, comprising a separate hardware line, which transmits the alarm signal (312) from the safety electronics (302) to the battery cell supervision unit (304) or to the battery management unit.

6. Battery system (300) according to one of the preceding claims, comprising a battery isolation unit (414), which isolates the battery system (300) from a consumer (402) depending on the alarm signal (312).

7. Battery system (300) according to one of the preceding claims, comprising a short-circuiting path, which connects the battery cell monitoring unit (304) in parallel with the battery cell (306) depending on the alarm signal (312).

8. Battery system (300) according to one of the preceding claims, wherein the battery cell (306) is a lithium-ion battery cell (306).

9. Motor vehicle comprising a battery system (300) according to one of the preceding claims, wherein the battery system (300) is connected to a drive system of the motor vehicle.

**Revendications**

1. Système de batterie (300) comportant
une unité de gestion de batterie ;
une unité de surveillance de cellule de batterie (304) ;
au moins une cellule de batterie (306), et
une électronique de sécurité (302) destinée à la cellule de batterie (306), comportant un premier comparateur (308) et une sortie de signal d'alarme (310) destinée à un signal d'alarme (312) ;
dans lequel le premier comparateur (308) compare une tension de cellule de batterie (410) de la cellule de batterie (306) à une valeur de seuil de tension prédéterminée (314) et génère le signal d'alarme (312) en fonction de la comparaison,
dans lequel la valeur de seuil de tension (314) est inférieure à la tension de cellule de batterie (410) lors d'un fonctionnement normal et est supérieure à une valeur de tension critique, dans lequel ladite au moins une cellule de batterie (306) est connectée en parallèle à une électronique de suivi (208),
**caractérisé en ce qu'**une limite inférieure de tension spécifiée de l'électronique de suivi (208) ou de l'unité de surveillance de cellule de batterie (304) constitue la valeur de tension critique.

2. Système de batterie (300) selon la revendication 1, dans lequel l'électronique de suivi comprend un deuxième comparateur destiné à surveiller la tension de cellule de batterie de la cellule de batterie lors d'un fonctionnement normal.

3. Système de batterie (300) selon la revendication 1 ou 2, dans lequel le premier comparateur (308) génère le signal d'alarme (312) lorsque la comparaison indique que la tension de cellule de batterie (410) est inférieure à la valeur de seuil de tension (314).

4. Système de batterie (300) selon l'une quelconque des revendications précédentes, dans lequel le premier comparateur (306) comporte une résistance d'entrée de plusieurs kilohms ou de plusieurs mégohms.

5. Système de batterie (300) selon l'une quelconque des revendications précédentes, comportant une ligne matérielle séparée qui transmet le signal d'alarme (312) de l'électronique de sécurité (302) à l'unité de surveillance de cellule de batterie (304) ou à l'unité de gestion de batterie.

6. Système de batterie (300) selon l'une quelconque des revendications précédentes, comportant une unité de séparation de batterie (414) qui sépare le système de batterie (300) d'un consommateur (402) en fonction du signal d'alarme (312).

7. Système de batterie (300) selon l'une quelconque des revendications précédentes, comportant un trajet de court-circuit qui connecte en parallèle l'unité de surveillance de cellule de batterie (304) à la cellule de batterie (306) en fonction du signal d'alarme (312).

8. Système de batterie (300) selon l'une quelconque des revendications précédentes, dans laquelle la cellule de batterie (306) est une cellule de batterie au lithium-ions (306).

9. Véhicule automobile comportant un système de batterie (300) selon l'une quelconque des revendications précédentes, dans lequel le système de batterie (300) est relié à un système d'entraînement du véhicule automobile.

# Fig. 1
## Stand der Technik

# Fig. 2
## Stand der Technik

# Fig. 3

# Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6339526 B1
- EP 2075892 A2